# EUROPEAN PATENT APPLICATION

(11) **EP 1 638 143 A2**
(43) Date of publication of application: **22.03.2006**
(21) Application number: 05255608.1
(22) Date of filing: 14.09.2005
(51) Int. Cl.: H01L 23/433, H01L 23/427

(54) **Heat-transfer devices**

(30) Priority: 21.09.2004 US 946571; 31.01.2005 US 47328
(71) Applicant: LUCENT TECHNOLOGIES INC., Murray Hill, New Jersey 07974-0636 (US)
(72) Inventor: Ewes, Ingo, 90425 Nuremberg (DE); Hodes, Marc Scott, New Providence New Jersey 07974 (US); Holmes, Paul D., Malmesbury SN16 9PF (GB); Kolodner, Paul Robert, St. Hoboken New Jersey 07030 (US)
(74) Representative: Sarup, David Alexander

(57) **Abstract**

Techniques for heat removal are provided. In one illustrative embodiment, a heat-transfer device is provided. The heat-transfer device comprises at least one heat-dissipating structure thermally connectable to at least one heat source, wherein the heat-dissipating structure comprises at least two components thermally coupled to each other and configured to slide relative to one another. In another illustrative embodiment, the heat-transfer device comprises at least one heat-dissipating structure thermally connectable to at least one heat source, wherein the heat-dissipating structure comprises at least two components thermally coupled to each other and configured to slide relative to one another, one or more of the components comprising one or more heat-dissipating fins configured to dissipate at least a portion of heat from the heat source to air proximate to the device.

## Description

### Field of the Invention

This invention relates generally to heat removal from electronic devices and, more specifically, to improved heat-transfer devices for heat removal from electronic devices.

### Background of Invention

Circuit packs and modules typically have one or more printed wire board (PWB)-mounted integrated circuits (ICs) that dissipate enough heat that cooling by simple, un-enhanced natural convection and/or by heat conduction through the PWB is insufficient to keep junction temperatures below maximum operating limits. Generally, passive cooling of these ICs may be obtained by thermally connecting them to heat-dissipating structures, such as heat sinks, which in turn may be cooled by forced air when necessary.

Cooling using this general technique, however, is not always easy to achieve. For instance, variations in IC stack-up height and parallelism present a notable problem. Given these variations, it is often difficult to achieve a proper, reliable contact between surfaces to maintain a good thermal path. For example, certain devices, such as the LambdaUnite™ product, commercially available from Lucent Technologies Inc. of Murray Hill, New Jersey, have an aluminum cooling plate mounted above, and parallel to, the PWB to provide enhanced cooling of one or more ICs mounted on the PWB.

A problem that may be encountered in making a proper thermal connection between the ICs and the cooling plate is that the distance between the plate and the ICs can vary, both because of IC stack-up height variations and because of thermal expansion of the entire assembly. Additionally, the two surfaces to be thermally connected may not be sufficiently parallel and in fact may shift relative to one another as the assembly is transported or thermally or mechanically stressed. Typically, these height variations and misalignments may be compensated for by use of thermal gap fillers or thick layers of thermal grease, both of which have low thermal conductivity.

Therefore, it would be desirable to have low thermal resistance heat dissipation techniques to accommodate the variations and dynamics in assembly architecture.

### Summary of the Invention

Techniques for heat removal are provided. In one illustrative embodiment, a heat-transfer device is provided. The heat-transfer device comprises at least one heat-dissipating structure thermally connectable to at least one heat source, wherein the heat-dissipating structure comprises at least two components thermally coupled to each other and configured to slide relative to one another.

In another illustrative embodiment, a heat-transfer device is provided. The heat-transfer device comprises at least one heat-dissipating structure thermally connectable to at least one heat source, wherein one or more components of the heat-dissipating structure comprise a heat-pipe spring.

In yet another illustrative embodiment, an apparatus is provided. The apparatus comprises at least one heat source; and at least one heat-dissipating structure thermally connectable to the at least one heat source, wherein the heat-dissipating structure comprises at least two components thermally coupled to each other and configured to slide relative to one another.

In a further illustrative embodiment, a method of providing heat transfer is provided. The method comprises the following steps. At least one heat-dissipating structure is thermally connected to a heat source. One or more slidable, thermally connected components of the heat-dissipating structure are then provided to the heat source.

In another illustrative embodiment, a heat-transfer device is provided. The heat-transfer device comprises at least one heat-dissipating structure thermally connectable to at least one heat source, wherein the heat-dissipating structure comprises at least two components thermally coupled to each other and configured to slide relative to one another, one or more of the components comprising one or more heat-dissipating fins configured to dissipate at least a portion of heat from the heat source to air proximate to the device.

In yet another illustrative embodiment, a method of providing heat transfer is provided. The method comprises the following steps. At least one heat-dissipating structure is thermally connected to a heat source. The heat-dissipating structure comprises at least two components thermally coupled to each other and configured to slide relative to one another, one or more of the components comprising one or more heat dissipating fins configured to dissipate at least a portion of heat to air proximate to the device.

### Brief Description of the Drawings

The present invention will be better understood from reading the following description of non-limiting embodiments, with reference to the attached drawings, wherein below:
FIG. 1 is a diagram illustrating two conventional heat-transfer device configurations;
FIG. 2 is a diagram illustrating another conventional heat-transfer device configuration;
FIG. 3 is a diagram illustrating an exemplary heat-pipe spring heat-transfer device;
FIG. 4 is a diagram illustrating an exemplary heat-pipe spring evaluation model;
FIGS. 5A-B are diagrams illustrating an exemplary heat-transfer device having a heat-transfer collet;
FIG. 6 is a diagram illustrating an exemplary heat-transfer device having a square peg and hole configuration;
FIGS. 7A-B are diagrams illustrating an exemplary heat-transfer device having a ball and socket configuration;
FIG. 8 is a diagram illustrating an exemplary heat-transfer device having nested fins;
FIG. 9 is a diagram illustrating an exemplary heat-transfer device having double-nested fins;
FIG. 10 is a diagram illustrating exemplary dimensions of a bottom heat-transfer block of a double nested fin heat-transfer device;
FIG. 11 is a diagram illustrating exemplary dimensions of a middle heat-transfer block of a double nested fin heat-transfer device;
FIG. 12 is a diagram illustrating exemplary dimensions of a top heat-transfer block of a double nested fin heat-transfer device;
FIG. 13 is a diagram illustrating exemplary dimensions of a bottom heat-transfer block of a single nested fin heat-transfer device;
FIG. 14 is a diagram illustrating exemplary dimensions of a top heat-transfer block of a single nested fin heat-transfer device;
FIG. 15 is a diagram illustrating an exemplary rail and cap thermal connection;
FIG. 16 is a diagram illustrating an exemplary interlocking fin configuration;
FIGS. 17A-B are diagrams illustrating another exemplary interlocking fin configuration;
FIG. 18 is a diagram illustrating an exemplary heat-transfer device having a bellows heat-pipe;
FIG. 19 is a cut-away diagram illustrating an exemplary heat-transfer device having a bellows heat-pipe;
FIG. 20 is a chart illustrating computed thermal resistance values;
FIGS. 21A-D are diagrams illustrating exemplary fasteners for the nested fin heat-transfer device; and
FIG. 22 is a diagram illustrating an exemplary heat-transfer device having heat-dissipating fins.

It should be emphasized that the drawings of the instant application are not to scale but are merely schematic representations, and thus are not intended to portray the specific dimensions of the invention, which may be determined by skilled artisans through examination of the disclosure herein.

### Detailed Description of the Invention

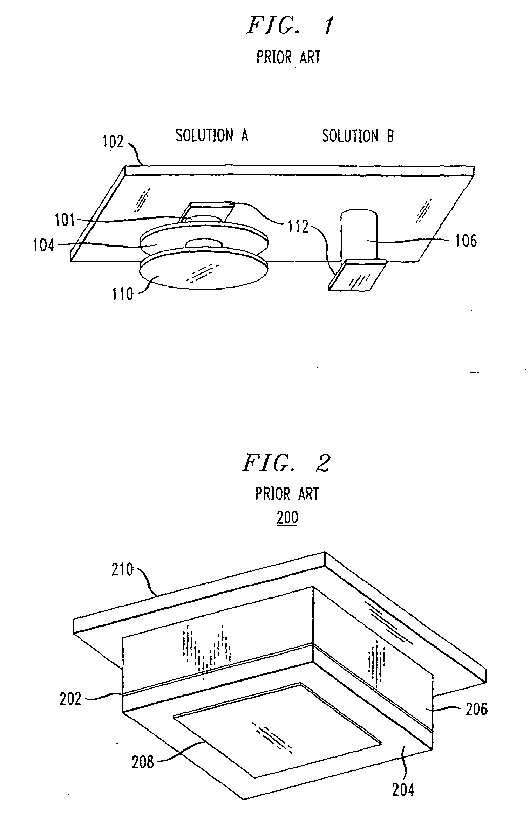

Prior to describing the embodiments of the present invention, several conventional heat dissipation assemblies will be described with reference to FIG. 1 and FIG. 2. FIG. 1 is a diagram illustrating two conventional heat-transfer device configurations. In a first configuration, labeled "Solution A," thermal contact between cooling plate 102 and an integrated circuit (IC) (not shown) is made using a heat-transfer structure consisting of aluminum rod 101, e.g., 15 millimeters (mm) in diameter, the length of which bridges most of the gap between the top of the IC and the bottom of cooling plate 102, e.g., a 14.5 mm gap.

The bottom surface of the aluminum rod is attached, e.g., glued, via socket plate 110 to a top surface of the IC, providing a thermal interface with relatively small thermal resistance. Socket plate 110 may have a diameter of up to about 40 mm (depending on the size of the IC). The variable gap remaining between the top of aluminum rod 101 and the underside of cooling plate 102 is filled with thermal pad 112, e.g., a thermal gap filler, such as Thermagon T-flex 6130™, which is typically greater than or equal to about 2.5 mm thick. Because of its low thermal conductivity (e.g., about three Watts per meter-Kelvin (W/m-K)), this thermal gap filler presents a thermal resistance of about six degrees Celsius per Watt (°C/W). In order to mitigate this high thermal resistance, aluminum rod 101 can include a circular fin 104, at mid-height, to enhance heat transfer to the cooling airflow (which generally flows through the assembly parallel to cooling plate 102). Machining this level of detail, however, adds cost, as does the manual process employed to attach socket plate 110 to the IC.

In a second, more economically viable, configuration, labeled "Solution B," a heat-transfer structure, e.g., consisting of aluminum rod 106, is screwed to cooling plate 102, and thermal pad 112 is placed between aluminum rod 106 and a top surface of the IC (not shown). Alternatively, aluminum rod 106 may be eliminated and only thermal pad 112 is present between cooling plate 102 and the top surface of the IC.

According to the configurations of Solutions A and B, the distance between cooling plate 102 and the bottom of the IC (e.g., top of the printed wire board (PWB) on which the IC is typically mounted (not shown)) can be as much as about 14.5 mm. In both Solutions A and B, there must be enough compressive force to make good thermal contact to thermal pad 112. In either configuration, a layer of thermal grease (not shown) may also be employed in place of, or in conjunction with, thermal pad 112. The same sufficient compressive force is also required when thermal grease is employed. In fact, thermal pads, e.g., thermal pad 112, make worse thermal contact to metal surfaces than thermal grease at any given amount of applied pressure.

Disclosed herein are heat-transfer devices which solve the thermal problems associated with use of thick thermal pads and/or layers of thermal grease. In one exemplary embodiment, as will be described in detail below, a flexible thermal connection or heat-transfer structure is disclosed having a large thermal conductance and acting like a flexible spring under compression. Such a structure provides a resilient mechanical and thermal connection between two surfaces that may not be precisely parallel and whose separation can vary over some range. Further, multiple embodiments will be presented in detail below having different contact areas, height ranges and spring constants.

The structures of the present invention may be constructed from a minimal number of basic components, so as to reduce costs. Therefore, a simple design and construction is an important factor.

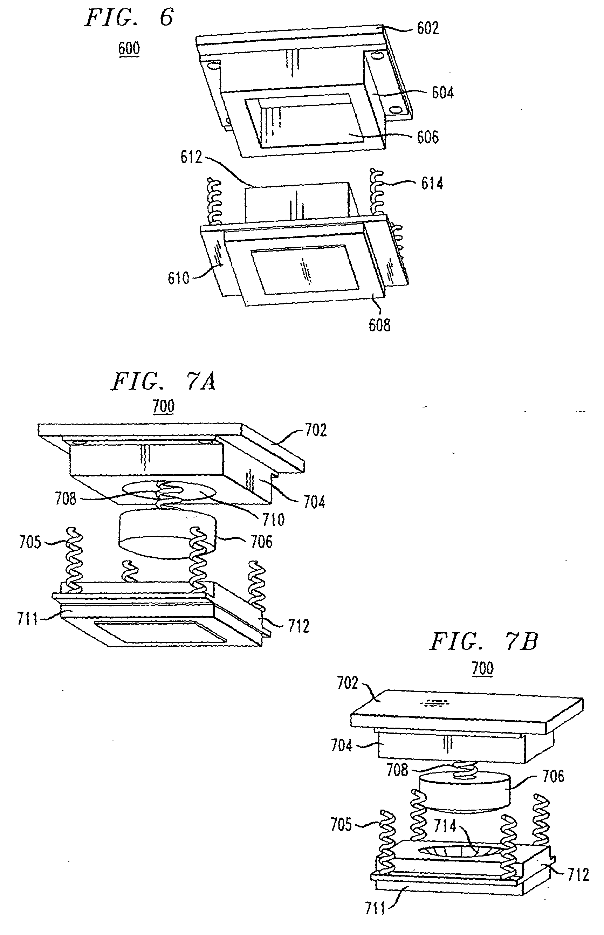

As will be described, for example, in conjunction with the description of FIG. 6, below, one exemplary embodiment of the present invention comprises a square peg, thermally attached to an IC device package, that slides into a mating hole in a heat-transfer block attached to the underside of a cooling plate. The mating surfaces are covered with a thin layer of thermal grease to improve thermal contact.

The term "slide," as used herein, denotes the movement, or changing position, of at least a portion of at least one surface in relation to at least a portion of at least one other surface. For example, as described immediately above, a square peg slides into a mating hole.

Springs may be employed to push the two components apart, providing resilience. Thus, this particular structure can adapt to variations in spacing between the surfaces being thermally connected.

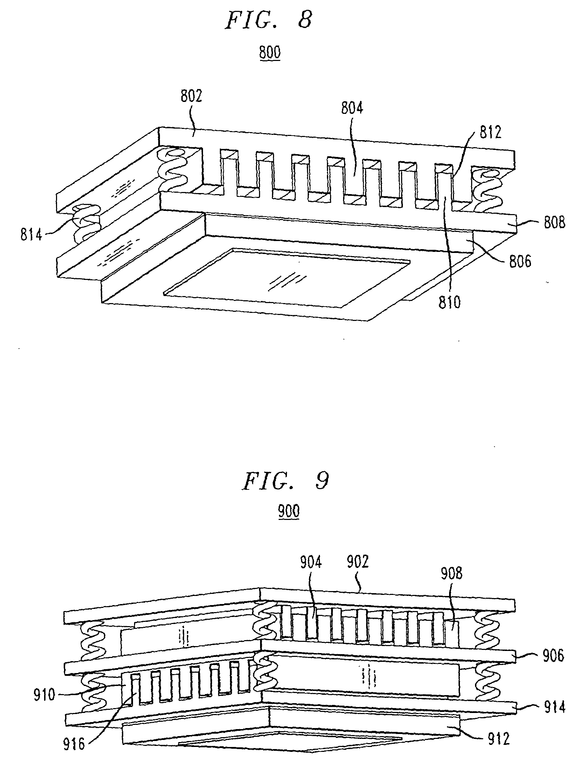

In another exemplary embodiment, as will be described, for example, in conjunction with the description of FIG. 8, below, a heat dissipation structure comprises oppositely-facing aluminum heat-transfer blocks (that may be held together with springs to provide resistance to compression) with closely nested fins having thermal grease filling the gaps between adjacent fins. This structure provides nearly the same thermal conductance as a solid aluminum block of the same outer dimensions, but is mechanically flexible and compressible, and can also adjust to angular misalignments (in one or more directions) between one or more thermally connected surfaces.

In a further exemplary embodiment, as will be described, for example, in conjunction with the description of FIG. 9, below, two heat-transfer blocks may comprise fins oriented at 90 degrees to each other that are connected thermally by an intermediate heat-transfer block having two orthogonal sets of mating fins with thermal grease filling the gaps between adjacent fins. This structure can adapt to arbitrary non-parallelism between the surfaces to be thermally connected (e.g., tilt between the surfaces to be thermally connected with any orientation). In an exemplary embodiment, the structure can tilt up to about ten degrees.

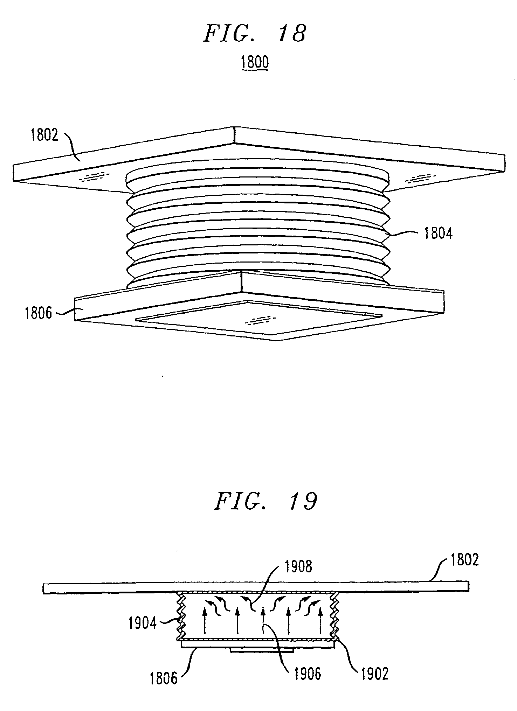

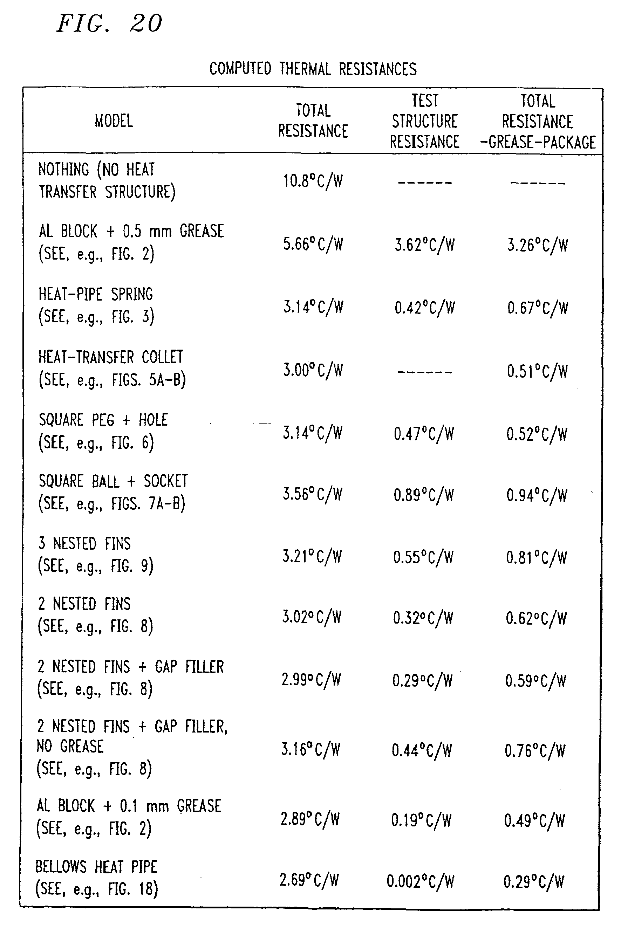

In yet another exemplary embodiment, as will be described, for example, in conjunction with the description of FIG. 18, below, a bellows heat-pipe is employed which fulfills the mechanical requirements of flexibility and compressibility. This embodiment is favorable for high-power applications. Derivations of the bellows heat-pipe structure, namely a heat-pipe spring, may be employed, wherein the heat-pipe would function as a heat dissipater as well as a spring. This structure is particularly useful in cooling very small ICs, because its high thermal conductivity compensates the spreading resistances associated with a small IC and a small diameter heat-pipe.

All of the heat dissipation structures provided herein eliminate the large thermal resistances associated with thick layers of thermal grease or thermal pads. Thus, according to an exemplary embodiment of the present invention, thermal grease layers having a thickness of less than or equal to about 0.5 mm, e.g., less than or equal to about 0.3 mm, and less than or equal to about 0.1 mm, are employed. For example, the thickness of the thermal grease layers may be independent of component stack-up height variations, misalignment and thermal expansion (which is not the case with conventional gap filler solutions). It is important to note that according to one or more of the exemplary embodiments presented herein and described in detail below, the thicknesses of the thermal grease layers do not change substantially during movement, e.g., of components relative to other components.

The thermal performance of each of the above highlighted configurations has been modeled using ICEPAK™ computational fluid dynamics (CFD) software (which allows for the analysis of the interrelationship of system components and how placement of the components on a circuit board affects the thermal behavior of the system). Each examined configuration is represented by a heat-transfer structure that connects an IC with a cooling plate, e.g., in the presence of a cooling airflow. Some of the structures presented herein are chosen as being representative of the LambdaUnite™ product.

The ICEPAK™ CFD software solves conduction problems (e.g., heat-transfer problems concerning the conduction of heat through solid materials) and convection problems (e.g., heat-transfer problems concerning the transfer of heat into the moving air), and thus yields temperature profiles on any surface in each of the examined heat-transfer structures. The definition of convection is heat transfer via motion of a fluid (such as air). From the temperature profiles, thermal resistances are computed to enable a comparison of the performances of the various structures. Many of the configurations evaluated have the same footprint, so that none has a geometric advantage in terms of spreading resistance.

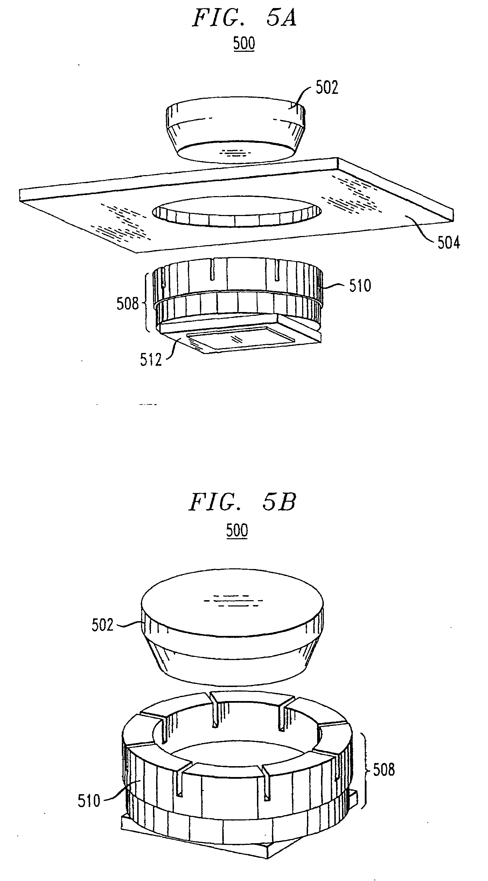

All structures, except for the structure shown in FIG. 2 and described below (which was evaluated with various thermal grease layer thicknesses), include a 0.1 mm thick layer of thermal grease on a top surface of an IC package. In all structures except the heat-transfer structure comprising a heat-transfer collet, as will be described, for example, in conjunction with the description of FIGS. 5A-B, below, the thermal resistance at the interface between the heat sink component(s) and the bottom surface of the cooling plate is assumed to be zero. A baseline computation was also performed with no heat-transfer structure or thermal grease.

FIG. 2 is a diagram illustrating another conventional heat-transfer device configuration. As shown in FIG. 2, heat-transfer device 200 comprises aluminum block 206 (having the same lateral dimensions as IC package 204, for example, 30 mm by 30 mm, which fills most of the gap between IC package 204 and cooling plate 210). To allow for variations in the height and in the dimensions of IC package 204, which comprises IC 208 (a heat source), a gap is designed into this structure to be filled with thermal grease layer 202 (or in the alternative, a thermal pad). In practice, the thickness of thermal grease layer 202 can be as much as 0.5 mm. This structure is typically used in many circuit packs and is used herein as a reference representing the highest thermal resistance configuration employable. In contrast with a thermal grease layer thickness of 0.1 mm, this model serves as a low thermal resistance baseline against which to directly compare the performance of the other heat-transfer structures tested. Namely, in this configuration, the device shown in FIG. 2 represents an ideal configuration, a block, e.g., aluminum block 206, with high thermal conductivity and a grease layer, e.g., thermal grease layer 202, of minimal thickness.

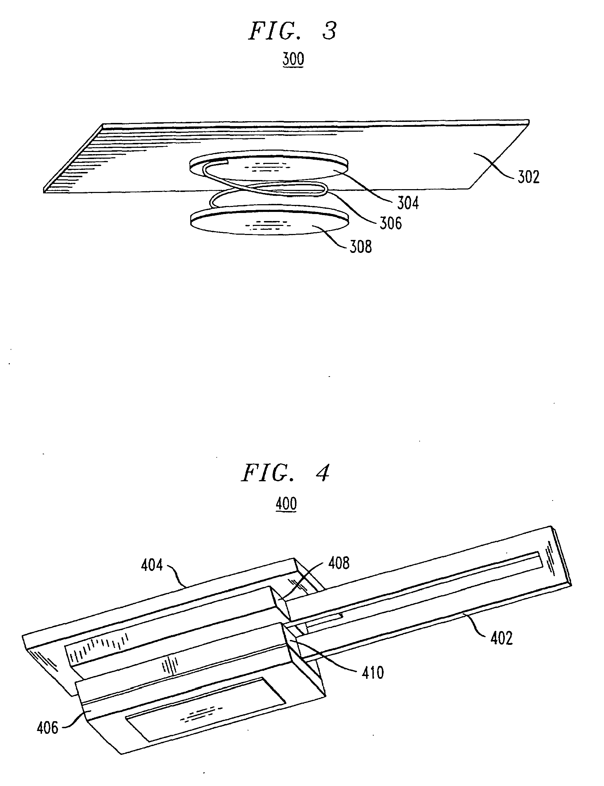

FIG. 3 is a diagram illustrating an exemplary beat-pipe spring heat-transfer device. Namely, in FIG. 3, heat-pipe spring heat-transfer device 300 comprises several components, including cooling plate 302, top thermal plate 304 (thermally connected to cooling plate 302), heat-pipe spring 306 and bottom thermal plate 308 (thermally connected to an IC package (not shown)). Heat-pipe spring 306 comprises a hollow metal tube, e.g., copper, with an internal surface at least a part of which is covered with a porous layer, i.e., a wick. As shown in FIG. 3, heat-pipe spring 306 is formed into a helical configuration making it elastic, and functioning similar to a conventional compressible spring, e.g., exhibiting resiliency. Thus, the spring action of heat-pipe spring 306 pushes bottom plate 308 into thermal contact with the IC package, compensating for variations in chip height and parallelism.

In operation, heat-pipe spring 306 is evacuated, filled with a small quantity of fluid (typically water) and then sealed. Heat introduced at the "hot end" of heat-pipe spring 306 causes the fluid to vaporize there. The vapor migrates to the "cold end" of heat-pipe spring 306, where it condenses. The wick then returns the condensed liquid back to the hot end of heat-pipe spring 306, e.g., by capillary pressure. Heat-pipe spring 306 can exhibit an effective thermal conductivity that is about ten to about 100 times that of metals, such as copper. In an exemplary embodiment, one or more springs are added to supplement the resiliency of heat-pipe spring 306.

FIG. 4 is a diagram illustrating an exemplary heat-pipe spring evaluation model. Namely, FIG. 4 is a computational model used to evaluate the performance of a heat-pipe spring heat-transfer device, e.g., heat-pipe spring heat-transfer device 300, described in conjunction with the description of FIG. 3, above. Similar to heat-pipe spring heat-transfer device 300, heat-pipe spring evaluation model 400 comprises several components, including, heat-pipe 402, cooling plate 404 and IC package 406, i.e., a heat source. According to the teachings presented herein, a heat source may comprise any electronic device, including, but not limited to, an IC.

As further shown in FIG. 4, one end of heat-pipe 402 is thermally connected to cooling plate 404 and the other end thermally connected to IC package 406 using heat transfer blocks 408 and 410, respectively. Further, a small layer of thermal grease may be present between one or more of the surfaces, e.g., between IC package 406 and heat transfer block 410. In an exemplary embodiment, the layer of thermal grease applied has a thickness of less than or equal to about 0.1 mm.

In this particular embodiment, heat-pipe 402 is configured to be a bent rod of rectangular cross section. For example, in one embodiment, heat-pipe 402 is a rectangular rod about 132 mm long having a cross section of about three mm by about four mm, and exhibits an effective thermal conductivity of 2.0 x 10⁴ W/m-K.

FIGS. 5A-B are diagrams illustrating an exemplary heat-transfer device having a heat-transfer collet. As shown in both FIGS. 5A-B, heat-transfer device 500 comprises several components, including, plug 502, cooling plate 504, rod 508 (having thin layer of thermal grease or adhesive 510 on an outer surface thereof) and IC package 512.

Namely, rod 508 is bored out (see FIG. 5B) and has axial slits that define thick, radially-expandable fins. For example, in one embodiment, rod 508, having a diameter of, e.g., 40 mm, and comprising aluminum, slides through a hole of nominally identical diameter in cooling plate 504, such that the collet can be pressed against the top of IC package 512, making a low-resistance thermal connection through thin layer of thermal grease or adhesive 510.

The radial-expandable fins of rod 508 are tightly pressed against the edge of the hole in cooling plate 504 by plug 502, e.g., a tapered plug, which can be pressed or screwed down from above. This radial expansion of the fins ensures a good, tight thermal contact between the heat-transfer collet and cooling plate 504. The ICEPAK™ model assumes that there is a 0.05 mm thick layer of thermal grease on the outside of rod 508.

An alternative method of connecting the collet to cooling plate 504 would be to thread rod 508 and cut mating threads into the hole in cooling plate 504. According to this exemplary embodiment, rod 508 may then be screwed into the threaded hole in cooling plate 504, e.g., until it bottoms out against IC package 512, and compresses the thermal grease. A nut, or nuts (for example, one on the top of cooling plate 504 and one on the bottom) could also be employed to tighten the connection and reduce thermal spreading resistance.

FIG. 6 is a diagram illustrating an exemplary heat-transfer device having a square peg and hole configuration. Namely, as shown in FIG. 6, heat-transfer device 600 comprises several components, including, cooling plate 602, with heat-transfer block 604 thermally connected thereto. Heat-transfer block 604 has square hole 606 present therein. Further, IC package 608, e.g., a heat source, comprises heat-transfer block 610 thermally connected thereto. Heat-transfer block 610 comprises square peg 612, the dimensions of which approximate at least a portion of the dimensions of square hole 606. One or more springs, such as springs 614, may be employed to provide resiliency between the thermally connected surfaces.

In an exemplary embodiment, one or more of heat-transfer blocks 604 and 610 are made of aluminum. Since square peg 612 can slide vertically in square hole 606, this structure has the added virtue of compressibility. Further, to account for machining tolerances, one or more of the walls of square hole 606 may be covered with a layer of thermal grease, e.g. to a maximum thickness of about 0.1 mm. The thicker the layer of thermal grease, the lower the thermal conductance, but the greater the flexibility to adapt to angular misalignments. Therefore, balancing of these two competing properties requires consideration. In this exemplary embodiment, the optimum lateral dimension of square peg 612 is 22 mm, leaving about a two mm vertical gap for compression.

Further, while a square geometry, e.g., a square peg and hole, is described in conjunction with the description of FIG. 6, it is to be understood that any suitable, complementary, geometries may be employed. For example, suitable geometries include, but are not limited to, round, oval or rectangular geometries.

FIGS. 7A-B are diagrams illustrating an exemplary heat-transfer device having a ball and socket configuration. As shown in FIGS. 7A-B, heat-transfer device 700 comprises several components, including, cooling plate 702 having heat-transfer block 704 thermally connected thereto. Central rod 706, having a convex lower surface, is attached to either cooling plate 702 or heat-transfer block 704 by spring 708. Further, heat-transfer block 704 has round hole 710 therein, round hole 710 having dimensions which approximate at least a portion of the dimensions of central rod 706.

IC package 7I1 comprises heat-transfer block 712 thermally connected thereto. Heat-transfer block 712 comprises one or more springs, e.g., springs 705, to provide resiliency against, e.g., heat-transfer block 704. Heat transfer block 712 also comprises depression 714, e.g., concave, approximately complementary to the convex lower surface of central rod 706. While this particular embodiment describes the complementary surfaces of the lower surface of central rod 706 and depression 714 in heat transfer block 712 to be convex and concave, respectively, other suitable complementary mating configurations may be employed, for example, the lower surface of central rod 706 and depression 714 in heat-transfer block 712 may be concave and convex, respectively.

The configuration shown illustrated in FIG. 7 adapts to non-parallelism as well as to height variations. Namely, central rod 706 can slide in and out of round hole 710 in heat-transfer block 704, allowing compressibility.

Round hole 710 may be lined with a thin layer, e.g., less than or equal to about 0.1 mm, of thermal grease. In addition, the convex lower surface of central rod 706 mates with depression 714 in heat-transfer block 712. This allows the structure to tilt in any direction, e.g., relative to the plane of the cooling plate, without changes in thermal conductance. Depression 714 and/or the convex surface of central rod 706 may be covered with a thin layer, e.g., less than or equal to about 0.1 mm, of thermal grease.

This structure is modeled in ICEPAK™ by modifying the heat-transfer device having a square peg and hole configuration, described, for example, in conjunction with the description of FIG. 6, above. In this modified model, central rod 706 is modeled as a 22 by 22 mm square peg and the extra thermal resistance of the mating surfaces, e.g., the convex lower surface of central rod 706 and depression 714 in heat-transfer block 712, is modeled by adding a 0.1 mm thermal grease layer, e.g., as was present on the walls of square hole 606 of FIG. 6, described above.

In a related embodiment, the structure of FIGS. 7A-B comprises heat-transfer blocks 704 and 712 only, each modified to have spherical mating surfaces. This simpler structure would exhibit large adaptability to tilt but no resilience.

FIG. 8 is a diagram illustrating an exemplary heat-transfer device having nested fins. As shown in FIG. 8, heat-transfer device 800 comprises several components, including upper heat-transfer block 802 comprising a plurality of fins 804 on one surface thereof. IC package 806 has lower heat-transfer block 808 thermally connected thereto. Lower heat-transfer block 808 comprises a plurality of fins 810 on one surface thereof, the dimensions of which approximate at least a portion of the space between fins 804. Likewise, the dimensions of fins 804 approximate at least a portion of the space between fins 810, such that fins 804 and fins 810 may be interdigitated. This interdigitating of fins 804 and fins 810 may be referred to herein as the "nested fins" model. Further, to account for machining tolerances, one or more surfaces of fins 804 and/or fins 810 may be covered with a layer of thermal grease 812, having a thickness of up to about 0.1 mm.

The nested fins provide a large surface area for good thermal contact, which, as mentioned above, may be enhanced by coating one or more surfaces of the fins with thermal grease. Resilience may be provided by springs, e.g., springs 814, shown here in the four corners of the structure. While the exemplary embodiment shown in FIG. 8 is described as having four springs, the teachings herein should not be construed as being limited to any particular number of springs or spring configurations. For example, according to an exemplary embodiment, six springs are employed. Further, as with all of the configurations having springs, as presented herein, the number of springs and/or the type of spring (e.g., having different spring constants) can be varied as desired, e.g., so as to minimize the number of parts employed. As with all of the resilient components described herein, the springs employed allow for relative motion or reorientation, which includes, but is not limited to one or more of moving, tilting, buckling, bending, deflecting and deforming, e.g., to provide proper thermal contact.

Fins 804 and fins 810 can slide relative to each other, e.g., along a direction perpendicular to upper heat-transfer block 802, allowing for compression. The structure can also tilt freely about an axis perpendicular to the nested fins, which means that a large non-parallelism between the PWB and upper heat-transfer block 802 can be compensated in that direction as well. Depending on the width of the gaps between the nested fins, limited tilt is also possible in the orthogonal direction.

In an exemplary embodiment, the ICEPAK™ model uses aluminum heat sinks having fins of height 6.5 mm, thickness two mm and spacing two mm. The nested fins overlap by 5.1 mm, allowing for compression by as much as 1.4 mm. The areas where the nested fins overlap are assumed to have excess thermal resistance corresponding to a 0.17 mm thick grease layer (since there is a greater amount of overlap in this structure, e.g., as compared to the heat-transfer model having a square peg and hole configuration, described in conjunction with the description of FIG. 6, above, a thicker layer of thermal grease is allowed).

With these dimensions, tilt by as much as 2.4 degrees, about an axis parallel to the nested fins, is possible. The lateral area covered by the nested fins matches that of the typical IC package employed, e.g., 30 mm by 30 mm. The total area of contact between the nested fins is 2,142 square millimeters (mm²), which is 2.4 times larger than the area of the above IC package. This large area of overlap compensates for the extra thermal resistance caused by the existence of layers of thermal grease and/or air gaps.

Two versions of this model were also contemplated and examined. First, the air gaps in the nested fin region, e.g., shown in FIG. 8 as existing between the tips of fins 804 and the top of lower heat-transfer block 808, or between the tips of fins 810 and the bottom of upper heat-transfer block 802, were filled with a material having a conductivity of three W/m-K, so as to simulate the effect of using a thermal gap-filler material there. Second, these air gaps in the nested fin region were filled with a material having a conductivity of three W/m-K, so as to simulate the effect of using a thermal gap-filler material there, as in the immediately preceding modification, but also with the thermal grease between the mating nested fins replaced with air. Regarding the second derivation, the possibility was explored of eliminating springs and using the compressive properties of the thermal gap-filler material for resiliency.

FIG. 9 is a diagram illustrating an exemplary heat-transfer device having double-nested fins. As shown in FIG. 9, exemplary heat-transfer device 900 comprises several components, including, upper heat-transfer block 902 having one or more fins 904 on a surface thereof, middle heat-transfer block 906 having one or more fins 908 interdigitated with and thermally connected to one or more of fins 904. Middle heat-transfer block 906 further has one or more fins 910 present on a side opposite, and oriented orthogonally, to fins 908. Heat-transfer device 900 also comprises IC package 912, thermally connected to lower heat-transfer block 914 having one or more fins 916 on a side thereof (opposite IC package 912). Fins 916 are interdigitated with and thermally connected to one or more of fins 910 of middle heat-transfer block 906. This configuration having an intermediate heat-transfer block, e.g., middle heat-transfer block 906, thermally coupling two other surfaces is referred to herein as the "double nested fin" model.

In an exemplary embodiment, middle heat-transfer block 906 comprises a one mm thick aluminum plate which can adapt completely to arbitrary variations in parallelism between surfaces, e.g., upper beat-transfer block 902 and IC package 912. In this exemplary embodiment, fins 904, 908, 910 and 916 are each four mm tall and overlap each other by about three mm, allowing for compression of up to about one mm.

As a reference, this structure, as well as the structures presented in conjunction with the description of FIGS. 6-8, above, were all compared with the solid aluminum block structure, e.g., described in conjunction with the description of FIG. 2, above, having 0.1 mm thick thermal grease layer (e.g., thermal grease layer 202). This calculation yields the minimum thermal resistance of the new structures that would be obtained if all the internal empty volumes and the associated thermal grease layers were absent and allows for the quantification of the degradation in thermal performance that is caused by those features.

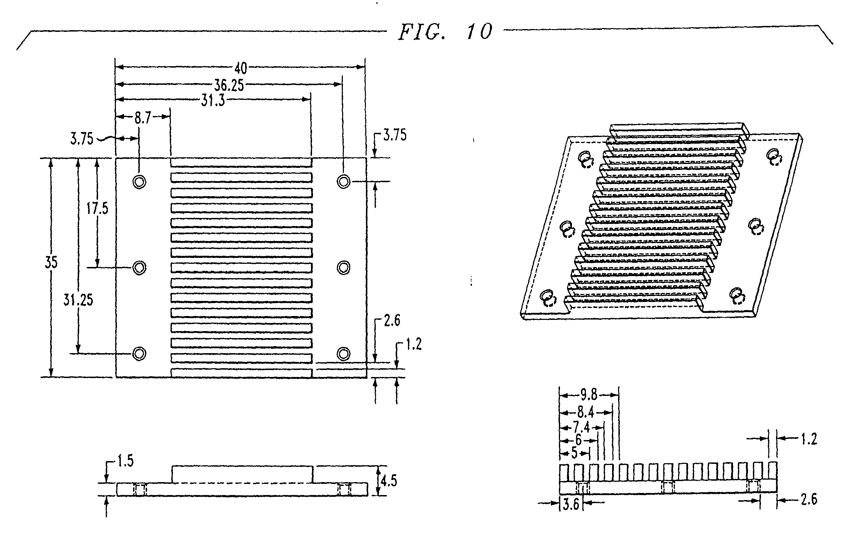

FIG. 10 is a diagram illustrating exemplary dimensions of a bottom heat-transfer block of a double nested fin heat-transfer device. All of the dimensions provided are in mm. The tolerances are ± 0.04 mm. Suitable materials for forming the bottom heat-transfer block include, but are not limited to, aluminum alloy Al 6061. The finish employed is clear chromate. After processing, all oil is removed. Further, all fins, except for the outer fins, are one mm thick. The outer fins are 1.2 mm thick. All six holes are tapped for M2x0.4 ISO threads.

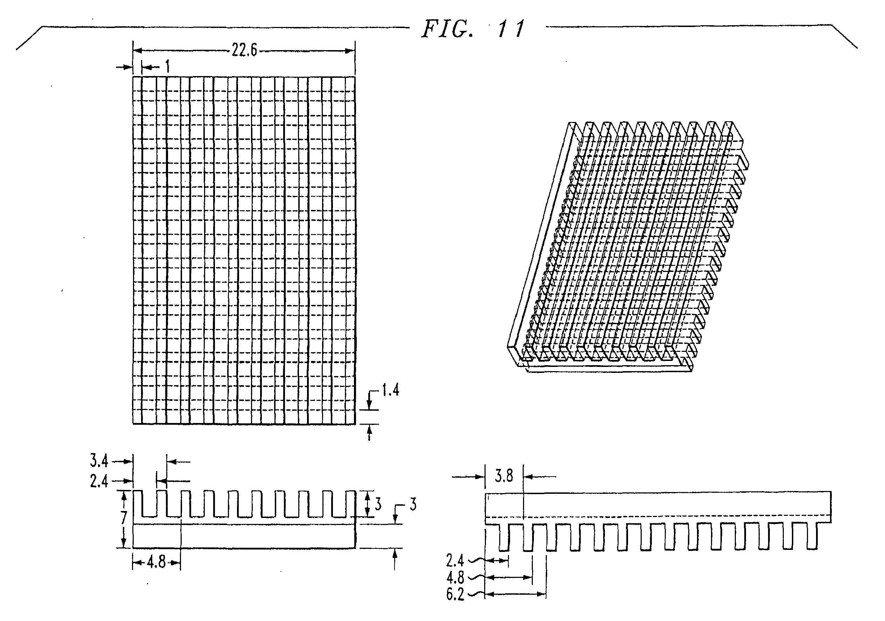

FIG. 11 is a diagram illustrating exemplary dimensions of a middle heat-transfer block of a double nested fin heat-transfer device. All of the dimensions provided are in mm. The tolerances are ± 0.04 mm. Suitable materials for forming the middle heat-transfer block include, but are not limited to, aluminum alloy Al 6061. The finish employed is clear chromate. After processing, all oil is removed.

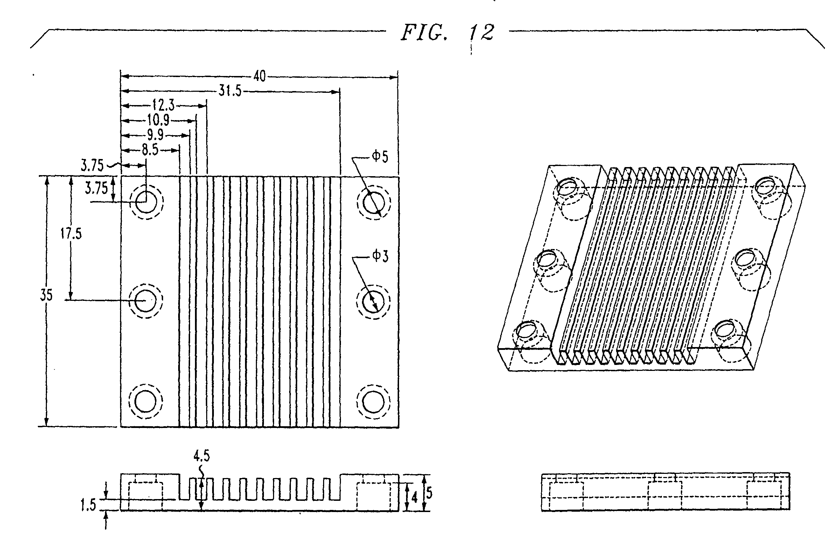

FIG. 12 is a diagram illustrating exemplary dimensions of a top heat-transfer block of a double nested fin heat-transfer device. All of the dimensions provided are in mm. The tolerances are ± 0.04 mm. Suitable materials for forming the top heat-transfer block include, but are not limited to, aluminum alloy Al 6061. The finish employed is clear chromate. After processing, all oil is removed.

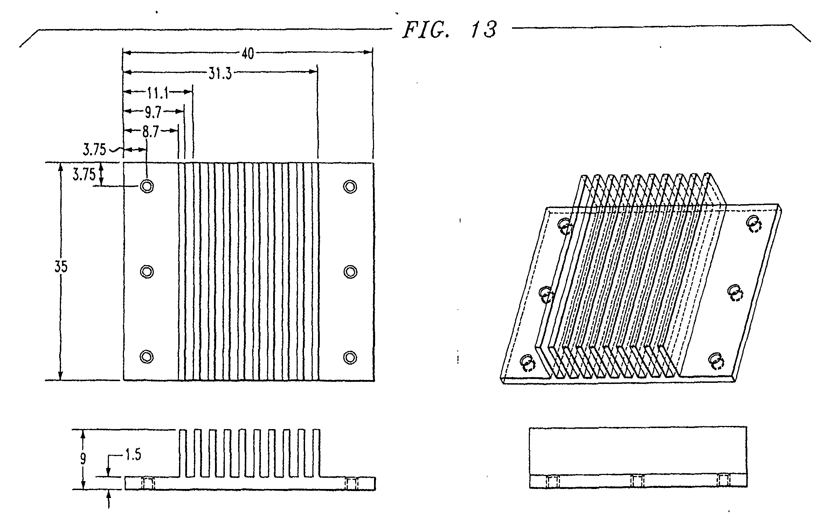

FIG. 13 is a diagram illustrating exemplary dimensions of a bottom heat-transfer block of a single nested fin heat-transfer device. All of the dimensions provided are in mm. The tolerances are ± 0.04 mm. Suitable materials for forming the bottom heat-transfer block include, but are not limited to, aluminum alloy A1 6061. The finish employed is clear chromate. After processing, all oil is removed.

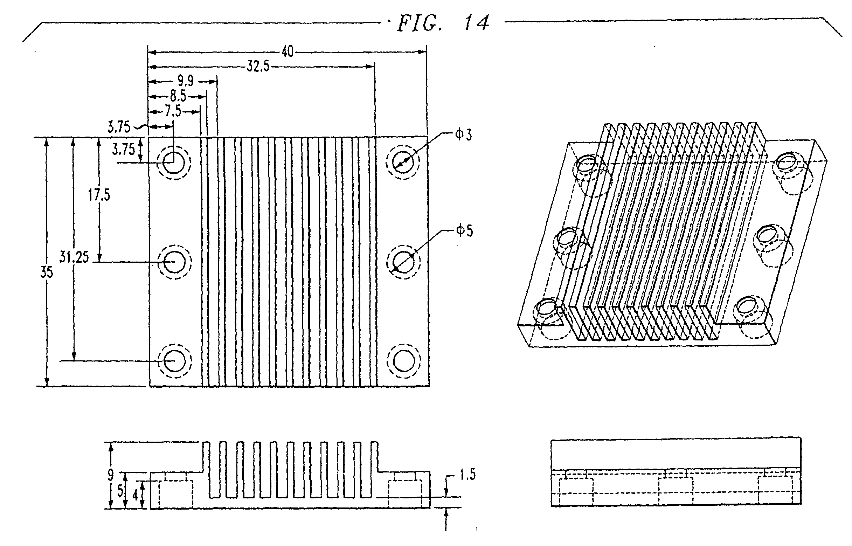

FIG. 14 is a diagram illustrating exemplary dimensions of a top heat-transfer block of a single nested fin heat-transfer device. All of the dimensions provided are in mm. The tolerances are ± 0.04 mm. Suitable materials for forming the top heat-transfer block include, but are not limited to, aluminum alloy Al 6061. The finish employed is clear chromate. After processing, all oil is removed. With regard to FIGS. 10-14, above, as well as with all figures presented herein, it is to be understood that the dimensions provided herein are merely exemplary and that other dimensions and configurations may be employed.

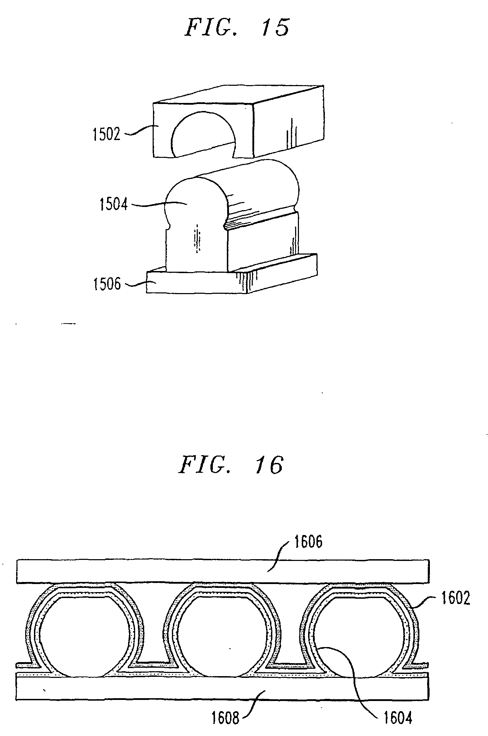

FIG. 15 is a diagram illustrating an exemplary rail and cap thermal connection. Namely, in FIG. 15, thermal connection 1502 comprises a cap configuration and thermal connection 1504 comprises a rail configuration mounted on heat-transfer block base 1506, complimentary to the cap configuration of thermal connection 1502. In an exemplary embodiment, this thermal connection configuration is produced using extrusion techniques, and is particularly suitable for applications requiring a single thermal connection, e.g., for small rectangular components.

FIG. 16 is a diagram illustrating an exemplary interlocking fin configuration. Namely, in FIG. 16, interlocking folded fins 1602 and 1604, attached to heat-transfer block bases 1606 and 1608, respectively, provide flexible, interlocking mechanical and thermal connections between heat-transfer block bases 1606 and 1608. This configuration can be employed to allow for enhanced airflow and conductive cooling.

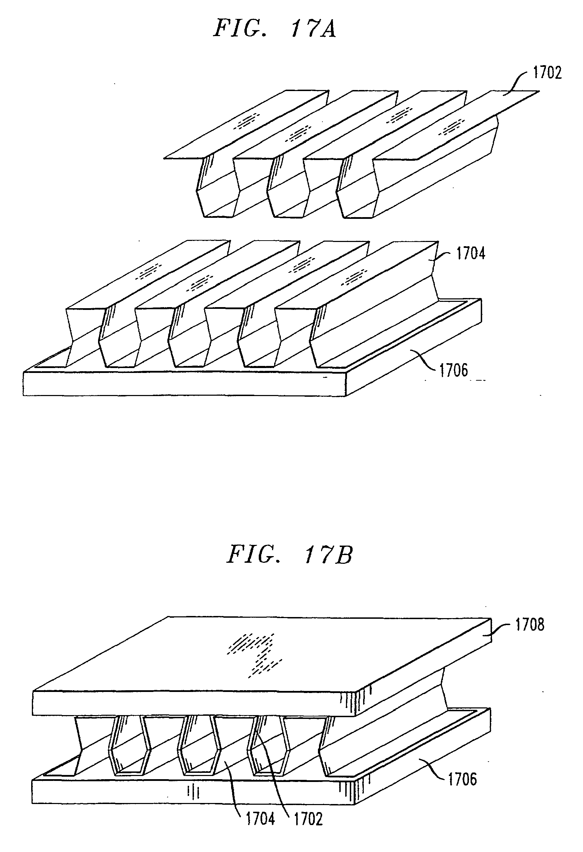

FIGS. 17A-B are diagrams illustrating another exemplary interlocking fin configuration. Namely, in FIG. 17A, wire frame model of folded fin 1702 is shown to be complementary to solid model of folded fin 1704, which is mounted on heat-transfer block base 1706. FIG. 17B shows wire frame model of folded fin 1702, now mounted on heat-transfer block base 1708, interlocked with the complementary solid model of folded fin 1704. By careful design of the folded fin heat sinks, it is possible to produce an interlocking structure suitable for use in automated production. The folded fins are preferably made from a thin material. The folded fins provide several notable advantages. First, a large surface area is provided for optimizing conduction and radiation coupling of the parts with or without a non-air thermal coupling aid, e.g., thermal grease. Second, a large surface area is provided for heat transfer to the surrounding air, which may be under natural flow or forced flow. Third, a predominately non-plastic deformation is allowed, thus providing a resiliency and compliancy over a variety of imperfections of the component parts of the heat sink structures coupled by the heat sink assembly as a whole.

FIG. 18 is a diagram illustrating an exemplary heat-transfer device having a bellows heat-pipe. As shown in FIG. 18, heat-transfer device 1800 comprises cooling plate 1802 thermally connected to bellows heat-pipe 1804, which in turn is thermally connected to IC package 1806. The basic vaporization/condensation heat-transport mechanism utilized in heat-pipes, as described above, can also be employed in other geometries. Bellows heat-pipes are described, for example, in Babin et al., *Experimental Investigation of a Flexible Bellows Heat Pipe For Cooling Discrete Heat Sources,* 112 J. HEAT TRANSFER 602-607 (1990) and U.S. Patent Number 5,647,429 issued to Oktay et al., entitled "Coupled, Flux Transformer Heat Pipes," the disclosures of which are incorporated by reference herein.

FIG. 19 is a cut-away diagram illustrating an exemplary heat-transfer device having a bellows heat-pipe. Namely, FIG. 19 presents a cut-away view of a heat-transfer device having a bellows heat-pipe, such as that described in conjunction with the description of FIG. 18, above. As shown in FIG. 19, a bellows heat-pipe comprises housing 1902 and wick 1904. Namely, wick 1904 comprises a suitable porous layer, which may comprise a screen or a mesh, near, or on, the internal surfaces of housing 1902 (including the sidewalls and end caps).

As described above, during operation of a bellows heat-pipe, the bellows is evacuated and then filled with a suitable quantity of water (or other suitable fluid) before sealing. The arrows, e.g., arrows 1906 and 1908, indicate evaporation of the water at the heat source, e.g., IC package 1806, and condensation of the vapor on cooling plate 1802. Wick 1904 then serves to convey the condensate back to the heat source.

The structure is elastic and compensates for non-parallelism between its top and bottom surfaces. Because of the high thermal efficiency of heat transport in this kind of structure, and because of its large area, the bellows heat-pipe represents the lowest thermal resistance of any of the structures presented herein. However, the bellows heat-pipe structure is relatively costly to produce and therefore its use may be reserved for high-power applications where no other solution can work.

In an exemplary embodiment, the bellows heat-pipe is modeled as a solid rectangular block, similar to that described in conjunction with the description of FIG. 2, above, of very high conductivity (e.g., k = 2.0 x 10⁴ W/m-K) and lateral dimensions of about 30 mm by about 30 mm.

The basic geometry used in the computational evaluation of the proposed heat-transfer structures was chosen to represent that of the LambdaUnite™ product. The simulations took place inside an enclosure having the dimensions of 300 mm by 300 mm by 25 mm. One 25 mm by 300 mm face of the enclosure had a spatially-uniform imposed flow of cooling air at seven meters per second (m/sec), and the convection problem, e.g., the transfer of heat into moving air, as described above, was solved for turbulent flow (Re ≈ 11,000). The assumed inlet velocity of seven m/sec is substantially higher than that encountered in the LambdaUnite™ product (which in operation is closer to 1.4 m/sec). This difference causes the present simulations to underestimate the best-case spreading resistance by a small amount, e.g., by up to about 0.2 °C/W. This means that the results are conservative in the sense that the increases in total thermal resistance that are calculated for the various structures are in fact smaller (e.g., relative to the best results that could be achieved with a perfectly conductive structure) than would be observed with a lower airflow velocity.

The face opposite to the face providing the flow of cooling air was open to atmospheric pressure. The PWB was a 300 mm square plate of FR-4 having a conductivity of 0.35 W/m-K and a thickness of 1.6 mm. The cooling plate was a three mm thick slab of aluminum (conductivity of 205 W/m-K) of the same footprint as the PWB.

The distance between the top of the PWB and the bottom of the cooling plate was 15.4 mm. The top of the cooling plate was two mm below the top of the 25 mm tall computational domain. Simulations were also performed for a spacing of 10.4 mm and gave very similar results (data not shown).

The IC consisted of a ten by ten mm source dissipating ten watts (W) on the underside of a 2.4 mm thick by 30 x 30 mm ceramic package (k = 15 W/m-K). The bottom surface of the IC was in direct thermal contact with the PWB, with the result of about five percent of the heat being conducted away through the PWB in all models tested.

All models assumed a 0.1 mm thick layer of thermal grease (k = 0.6 W/m-K) between the top of the IC package and the bottom of the heat-transfer structure being tested. However, as noted above, the aluminum-block model, for example, as described in conjunction with the description of FIG. 2, above, was also tested with excess thermal grease (e.g., a 0.5 mm thick layer). The interface between the top of each heat-transfer structure being tested and the underside of the cooling plate was assumed to have zero contact thermal resistance, as to approximate a brazed or soldered attachment, except in the case of the heat-transfer collet, for example, such as was described in conjunction with the description of FIGS. 5A-B, above, where the circular hole in the cooling plate is assumed to be lined with a grease layer of thickness 0.05 mm or less.

Three different measures of thermal resistance were calculated, all based on the maximum temperatures computed for various surfaces in the model. First, a total thermal resistance through the test structure and the cooling plate was calculated. The total thermal resistance through the test structure and cooling plate was defined as the temperature difference max(Tₕₑₐₜ source) - T_{ambient} divided by the heat conducted through the top of the IC package. This total thermal resistance value is equal to the sum of the conductive and spreading resistances of all the structures in this thermal path, including the effective resistance of heat transfer from the cooling plate to the airflow. It gives a measure of the thermal performance of the entire model but does not reveal where the limiting resistances are.

Second, a test structure resistance was calculated. The test structure resistance was defined as the difference between the maximum temperatures measured on the bottom and top surfaces of the test structure, divided by the heat entering its bottom surface. This test structure resistance corresponds approximately to the conductance of the structure, but also includes some excess resistance due to heat spreading. Different definitions and measurements of the test structure resistance were also contemplated with the goal of defining an index that isolates the spreading component of this resistance.

Third, a total resistance minus the resistance of the ceramic IC package and the layer of thermal grease on its surface was calculated. This resistance value was used to represent the conductive resistance of the test structure plus the resistance associated with heat spreading out from the top surface of the test structure into the cooling plate, as well as the resistance associated with the convective transfer of heat into the airflow. With an infinitely conductive test structure, the resistance value would only represent the resistance associated with heat spreading out from the top surface of the test structure into the cooling plate and the resistance associated with the convective transfer of heat into the airflow and would represent the best thermal performance obtainable with the present geometry.

Because of the small size of the heat source, the thermal resistance of the IC package includes a contribution due to heat spreading. The University of Waterloo spreading-resistance calculator (which ignores internal resistances associated with the structure of the bellows heat-pipe, e.g., the resistance of the wick) was used to estimate this resistance to be 1.23°C/W.

The thermal grease layer also exhibits an effective spreading resistance, even though it is very thin, because the heat flux through the thermal grease layer is confined to an area that is not much bigger than that of the heat source. If the thermal grease layer thickness and the source size is used to estimate the resistance of the thermal grease layer, an estimate of 1.7°C/W is obtained. This resistance can be measured for each structure simply by measuring and comparing the heat source temperatures observed both with and without the thermal grease layer. The temperature difference observed varied from 12°C to 14°C, yielding a thermal resistance of about 1.3°C/W, which is roughly consistent with the estimated 1.7°C/W. This thermal resistance is computed separately for each model, in this manner.

FIG. 20 is a chart illustrating computed thermal resistance values. Namely, the chart shown in FIG. 20 displays the three thermal resistance values calculated for each of the present heat-transfer structures, as described above, including thermal resistance values for a configuration having no heat-transfer structure.

The true precision of all the results shown in FIG. 20 is about 0.1°C/W. Therefore, differences smaller than this are considered to be insignificant.

The aluminum block with a 0.5 mm thick thermal grease layer (row labeled "Al block + 0.5 mm grease") exhibited a very large thermal resistance that was dominated by the poor conductivity of the thermal grease layer. The thermal grease layer had the same thermal resistance as the gap fillers shown, for example, in FIG. 1, since, while the gap fillers are five times thicker than the thermal grease layer, they have five times higher thermal conductivity. Thus, all of the present heat-transfer structures examined performed better than conventional structures.

Further, the difference in all thermal resistance values between the nested fin structures (e.g., those rows labeled "3 nested fins," "2 nested fms," "2 nested fins + gap filler" and "2 nested fins + gap filler, no grease") and the aluminum block with thermal grease (e.g., row labeled "Al block + 0.1 mm grease") is small, e.g., only between about 0.1 - 0.3°C/W. This small difference in thermal resistance is all that is being lost by having empty volumes and thermal grease layers inside the nested-heat-sink structures, providing an extremely effcient thermal solution. Also, filling the voids of the nested fin structure with gap-filler material (see, for example, row labeled "2 nested fins + gap filler") improves the total thermal resistance by only a negligible amount, e.g., by less than 0.1°C/W.

Without the thermal grease layer between the nested fins, the nested fin structure performs surprisingly well. Namely, removing the thermal grease layer increases the total thermal resistance by only about 0.2°C/W.

The results quoted for the double-nested fin structure (see, for example, row labeled "3 nested fins'') assumed that the middle heat-transfer block is placed halfway between the outer surfaces. However, supplemental computations reveal that the thermal resistance is reduced slightly (e.g., by up to about 0.1°C/W) if the middle heat-transfer block is maximally displaced, e.g., moved the maximum distance possible, up or down from this position.

The heat-transfer structures having a heat-transfer collet, a square peg and hole and a ball and socket configuration, represented by the rows labeled "Heat-transfer collet" "Square peg + hole'' and "Square ball + socket," respectively, give about the same performance as the nested fin structures. The extra layer of thermal grease in the ball and socket configuration contributes an additional thermal resistance of about 0.4°C/W, due to the close proximity of the layer to the heat source, where the heat flux is localized. Placing this thermal grease layer in the structure further away from the heat source would reduce this localization effect.

The bellows heat-pipe configuration (see, for example, the row labeled "Bellows heat pipe"), having a negligible thermal resistance, represents the best possible result obtainable with the available cross-sectional area. For example, the third column (labeled "total resistance-grease-package") reveals that the bellows heat-pipe configuration provides a spreading thermal resistance on the cooling plate of 0.3°C/W. The heat-pipe spring configuration adds only 0.4°C/W to this spreading resistance.

Further, the bellows heat-pipe does not need to work very well to come close to the absolute minimum thermal resistance of 0.3°C/W. Reducing effective thermal conductivity of the bellows heat-pipe from 2.0 x 10⁴ W/m-K to the aluminum value of 205 W/m-K increases the thermal resistance by only 0.2°C/W.

In an additional configuration, several chips and heat-transfer structures are arrayed on a single PWB in order to investigate the effect of direct convective cooling of the heat-transfer structures and the effect of wind shadowing by upstream structures. The basic result of these experiments is that the location of upstream structures has a much larger effect on the cooling of downstream structures than does the size of the upstream structures. Therefore, according to an exemplary embodiment, the heat-transfer structures are made as large as is possible to maximize conductance, e.g., preferably the same area as the IC package, and the locations of the ICs on the PWB are staggered so that no heat-transfer structure sits directly downstream of any other structure.

Fabrication of the heat-transfer structures described above, e.g., specifically the nested fin structures, will now be described. The first issue that is encountered is how to fabricate the heat-transfer structure components themselves. The next issue is how to assemble the heat-transfer structure from the components. Issues pertaining to the thermal grease employed are also considered, as are attaching the heat-transfer structures to the cooling plate.

Heat sinks can be fabricated by processes including, but not limited to, extrusion, milling; sawing and spark erosion. Extruded heat sinks are the most economical to produce, however, the fins produced have a slightly triangular profile. As a result, as two such nested fins are pulled apart, the gaps between the fins tend to open up. Given the favorable performance of the nested fin structure without thermal grease, it is not clear whether this effect will cause a serious reduction in thermal performance. Thus, it may not be necessary to, e.g., mill or cut the fins individually.

A useful way for a manufacturer to provide the nested fin structure is as a completely assembled unit, so that they cannot come apart during installation. There are several ways to achieve this manufacturing. The simplest way to assemble the nested fin structure is to drill flat-bottomed, blind holes in the corners of the top and bottom heat-sink plates. The springs, being slightly oversized, are press-fit into the drilled holes. Thus, the springs alone hold the structure together until it is mounted. Further, if the outsides of at least the last few turns of the springs, e.g., the ends of, have knife-like edges it will aid in holding the springs in place in the holes.

In an alternative embodiment, a fastener is employed to hold the structure together, especially when the springs, described above, alone are insufficient to hold the structure together. Several types of fasteners can be used.

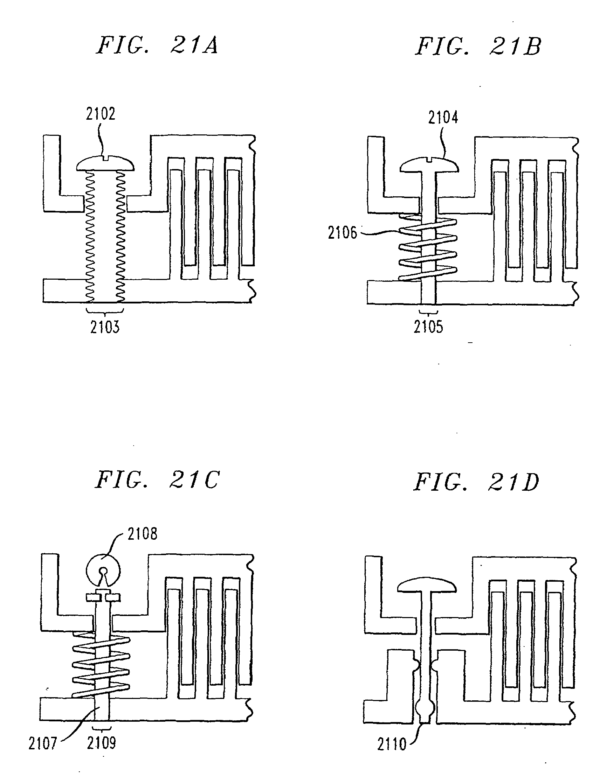

FIGS. 21A-D are diagrams illustrating exemplary fasteners for the nested fin heat-transfer device. FIG. 21A illustrates screw 2102 and tapped hole 2103. Alternatively, screw 2102 may comprise a self-tapping screw, e.g., a self-tapping sheet metal screw, suitable for tapping hole 2103. FIG. 21B illustrates press-fit nail 2104, e.g., press fit into hole 2105, and captured spring 2106. FIG. 21C illustrates press-fit pin 2107, e.g., press fit into hole 2109, with separate retainer clip 2108. FIG. 21D illustrates two-piece snap 2110.

Each of the fasteners shown in FIGS. 21A-D is designed so that it does not connect rigidly to both of the pieces of the structure. As such, the fasteners hold the structure together but do not limit compression or tilt. The counterbored holes in the top plate are deep enough that the top of the head of the fastener cannot protrude above the top plate even at full compression. FIGS. 21B and C illustrate that springs can be mounted on the fasteners, eliminating the need for separate holes to capture them.

The fastener shown in FIG. 21D bears a resemblance to the snaps on articles of clothing. Namely, one component of the fastener (shown integral with the bottom heat-transfer block) resembles a hollow rivet with an internal narrowing. The other component of the fastener resembles a nail with a compressible bump on its shaft. The two connector components are inserted into opposing stepped holes in the heat-sink plates and pressed together. This causes the compressible bump on the "nail" to pass through the narrowing inside the "rivet," trapping it, and holding the structure together.

Another alternative embodiment comprises using springs that have integral threaded end plugs. These threaded end plugs can screw into tapped holes in the base plates, e.g., heat-transfer blocks and hold the module together. Further, if the tapped holes are subsequently blocked by the mounting of the module, then the threaded inserts cannot accidentally come out.

The use of individual springs in, e.g., the four corners of the structure, as shown, for example, in FIGS. 6-9, provides only one potential way to impart compressibility to the nested fin heat-transfer structures. With numerous choices regarding the physical placement of the springs, as well as regarding the type of spring selected, the aggregate spring constant can be finely tuned. For example, a single, large spring, e.g., with square windings that wrap around the perimeter of the fins, could perform the same function as four individual springs placed at four corners. Such a single spring could be captured and retained by the flanges on the top and bottom surfaces.

Leaf springs could also be inserted into the gaps of the structure. These leaf springs could potentially exert force against the tips of the nested fins. Further, the aggregate spring constant could be adjusted by adding or removing individual leaves. This strategy would reduce the number of unique components needed to construct all members of a family of heat-transfer structures.

A gap-filler material may also be employed in gaps of the structure to provide compressibility. For example, a single-piece gap filler pad with appropriate rectangular slits could be fabricated by die-cutting and then slipped over each set of fins before assembly. Applying a pressure-sensitive adhesive on both sides of the pad can additionally be implemented to hold the assembly together as well as to provide resiliency. In this exemplary embodiment, the heat sinks could take their simplest form, namely, straight fins on a flat flange, with no need for screw holes or any other machining (a highly economically viable solution).

If thermal grease is employed, it should be a thixotropic material. Namely, it should exhibit a low resistance to shear, so as not to prevent the structures from compensating for stack-up height variations and misalignment, while being viscous enough not to ooze out of the gaps. A high shear resistance would dampen dynamic relative motion of the component heat sinks but would not reduce the total static force applied by the springs. The problem of excess grease oozing out under compression could be partly solved by making the two end fins slightly taller than the others. Under excess compression, these two fins would bottom out first, leaving gaps at the tips of all the other fins. These gaps would then function as reservoirs for any excess thermal grease to fill.

An alternative approach to prevent excess thermal grease from oozing out under compression, is to seal the structure. For example, in one embodiment, a band, preferably comprising some rubber or rubber-like material, is wrapped around the fins, sealing against the metal. Compression would merely buckle the band at mid-height without seriously compromising the seal against the metal.

Another issue is the minimization of the interfacial thermal resistance associated with the attachment of the heat-transfer structure, e.g., to a top surface of the IC package and/or to the bottom surface of the cooling plate. At the first interface, namely between the heat-transfer structure and the top surface of the IC package, thermal grease is employed and the compression provided by the structure assures that this layer has an optimally low thermal resistance. At the other interface, namely between the heat-transfer structure and the bottom surface of the cooling plate, all of the structures examined, except perhaps for heat-transfer structure having a heat-transfer collet, assume zero thermal resistance.

In fact, current technologies, such as the thermodynamically reactive metal foils produced by Reactive Nanotechnologies, Inc., can be employed to make solder connections in situations like the one under consideration here. When the instability is triggered (e.g., by a spark, illumination by a high-power laser or by a localized heat source, like a match), the foils ignite and bum rapidly, producing a very brief pulse of high temperature that can be used to melt solder. For the present application, the foil is coated on both sides with solder and flux, and is sandwiched between the top surface of the heat-transfer structure and the bottom surface of the cooling plate. The assembly is clamped together, and the foil is ignited. The heat pulse melts the solder and forms a low-thermal-resistance solder joint. Because the heat pulse is so brief, the region of high temperature is essentially confined to the thin region occupied by the foil, solder and flux. With this method of soldering, bowing of the cooling plate or other thermal distortion is avoided. Thus, a completely assembled heat-transfer structure, including thermal grease on internal mating surfaces, can be safely soldered to the cooling plate as received.

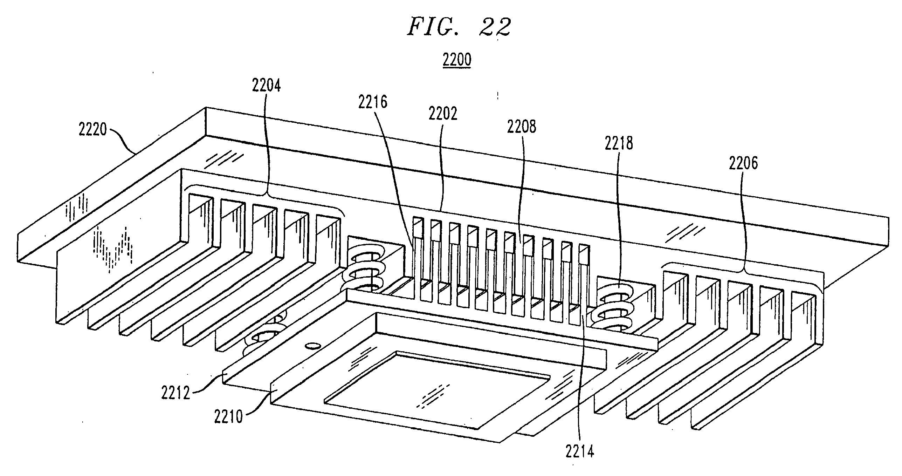

FIG. 22 is a diagram illustrating an exemplary heat-transfer device having heat-dissipating fins. As shown in FIG. 22, heat-transfer device 2200 comprises several components, including upper heat-transfer block 2202 having integrated heat-dissipating fins 2204 and 2206. As will be described in detail below, heat-dissipating fins 2204 and 2206 serve to dissipate heat to air proximate to heat-transfer device 2200. Thus, heat-dissipating fins 2204 and 2206 may be employed in instances where heat dissipation solely through, e.g., a cooling plate, is insufficient. Upper heat-transfer block 2202 further comprises a plurality of fins 2208 on one surface thereof.

According to the exemplary embodiment shown in FIG. 22, fins 2208 are shown to be on the same side of upper heat-transfer block 2202 as heat-dissipating fins 2204 and 2206, e.g., so as to provide a surface on upper heat-transfer block 2202 opposite IC package 2210 (described below) suitable for mounting to cooling plate 2220. However, it is to be understood that the teachings presented herein should not be limited to any particular configuration and heat-dissipating fins 2204 and 2206 may be located on any suitable surface of heat-transfer device 2200. For example, depending on the application, heat-dissipating fins 2204 and 2206 may be located on a side of lower heat-transfer block 2212 opposite fins 2208. Further, heat-dissipating fins 2204 and 2206 may be added to any of the structures described above.

IC package 2210 has lower heat-transfer block 2212 thermally connected thereto. Lower heat-transfer block 2212 comprises a plurality of fins 2214 on one surface thereof, the dimensions of which approximate at least a portion of the space between fins 2208. Likewise, the dimensions of fins 2208 approximate at least a portion of the space between fins 2214, such that fins 2208 and 2214 may be interdigitated. As above, interdigitated fins 2208 and 2214 may be referred to as "nested fins." Further, to account for machining tolerances and to assist heat transfer, one or more surfaces of fins 2208 and/or fins 2214 may be covered with a layer of thermal grease 2216, having a thickness of up to about 0.2 mm.

Resilience may be provided by springs, e.g., springs 2218, depicted here as being in the four corners of the structure. While the exemplary embodiment shown in FIG. 22 is described as having four springs, the teachings herein should not be construed as being limited to any particular number of springs or spring configurations. For example, according to an exemplary embodiment, six springs are employed. Further, the number of springs and/or the type of spring (e.g., having different spring constants) can be varied as desired, e.g., so as to minimize the number of parts employed.

The heat-transfer structure shown in FIG. 22 has a configuration similar to the heat-transfer device configuration shown in FIG. 8. For example, fins 2208 and 2214 can slide relative to each other, e.g., along a direction perpendicular to upper heat-transfer block 2202, allowing for compression. The structure can also tilt freely about an axis perpendicular to the nested fins, which means that a large non-parallelism between the PWB (to which IC package 2210 is mounted) and upper heat-transfer block 2202 can be compensated in that direction as well. Depending on the width of the gaps between the nested fins, limited tilt is also possible in the orthogonal direction.

Heat-dissipating fins 2204 and 2206 located on upper heat-transfer block 2202 serve to dissipate at least a portion of the heat generated by IC package 2210 to the ambient air flowing through them. The term "ambient," as used herein refers to the environment surrounding the heat-transfer device. For example, a portion of the heat from IC package 2210 will transfer through lower heat-transfer block 22I2 and upper heat-transfer block 2202 and into cooling plate 2220. A portion of the heat from IC package 2210 will also, however, transfer through lower heat-transfer block 2212 and upper heat-transfer block 2202 to heat-dissipating fins 2204 and 2206, which will, in turn, dissipate the heat into the ambient air (e.g., flowing through heat-dissipating fins 2204 and 2206).

Other configurations of heat-transfer device 2200 are contemplated herein. Thus, the present teachings herein should not be limited to any particular configuration. By way of example only, as described above, heat-dissipating fins 2204 and 2206 may be located on a side of lower heat-transfer block 2212 opposite fins 2208.

Further, the configuration of heat-transfer device 2200 is not limited to any particular number of heat-dissipating fins. By way of example only, heat-transfer device 2200 may comprise a single set of heat-dissipating fins, or alternatively, more than two sets of heat-dissipating fins located on one or more sides of upper heat-transfer block 2202.

It is to be understood that these and other embodiments and variations shown and described in the examples set forth above and the figures herein are merely illustrative of the principles of this invention and that various modifications may be implemented by those skilled in the art without departing from the scope and spirit of the invention.

## Claims

1. A heat-transfer device comprising:
at least one heat-dissipating structure thermally connectable to at least one heat source, wherein the heat-dissipating structure comprises at least two components thermally coupled to each other and configured to slide relative to one another.

2. The device of claim 1, further comprising one or more components configured to do one or more of moving, tilting, buckling, bending, deflecting and deforming.

3. A heat-transfer device comprising:
at least one heat-dissipating structure thermally connectable to at least one heat source, wherein one or more components of the heat-dissipating structure comprise a heat-pipe spring.

4. An apparatus comprising:
at least one heat source; and
at least one heat-dissipating structure thermally connectable to the at least one heat source, wherein the heat-dissipating structure comprises at least two components thermally coupled to each other and configured to slide relative to one another.

5. A method of providing heat transfer, the method comprising the steps of:
thermally connecting at least one heat-dissipating structure to a heat source; and
providing at least two slidable, thermally connected components of the heat-dissipating structure to the heat source.

6. A heat-transfer device comprising:
at least one heat-dissipating structure thermally connectable to at least one heat source, wherein the heat-dissipating structure comprises at least two components thermally coupled to each other and configured to slide relative to one another, one or more of the components comprising one or more heat-dissipating fins configured to dissipate at least a portion of heat from the heat source to air proximate to the device.

7. The device of claim 1, wherein the heat-dissipating fins are configured to have air flow therethrough.

8. The device of claim 1, wherein the heat-dissipating fins are grouped on one or more surfaces of one or more of the at least two components.

9. A method of providing heat transfer, the method comprising the steps of:
thermally connecting at least one heat-dissipating structure to a heat source, the heat-dissipating structure comprising at least two components thermally coupled to each other and configured to slide relative to one another, one or more of the components comprising one or more heat-dissipating fins configured to dissipate at least a portion of heat from the heat source to air proximate to the device; and
passing at least a portion of the heat through the one or more heat-dissipating fins.

10. An apparatus comprising:
at least one heat source; and
at least one heat-transfer device comprising at least one heat-dissipating structure thermally connectable to the at least one heat source, wherein the heat-dissipating structure comprises at least two components thermally coupled to each other and configured to slide relative to one another, one or more of the components comprising one or more heat-dissipating fins configured to dissipate at least a portion of heat from the heat source to air proximate to the device.
